# EUROPEAN PATENT APPLICATION

(11) **EP 4 742 529 A1**
(43) Date of publication of application: **13.05.2026**
(21) Application number: 24306890.5
(22) Date of filing: 12.11.2024
(51) Int. Cl.: H03F 1/02, H03F 1/56, H03F 3/195, H03F 3/21, H03F 3/213, H03F 3/24, H01L 23/66

(54) **DUAL POWER AMPLIFIER WITH TUNABLE OUTPUT COMBINER CIRCUIT**

(71) Applicant: NXP USA, Inc., Austin, TX 78735 (US)
(72) Inventor: Dong, Yuanyuan, 31023 Toulouse (FR); Scatamacchia, Damien, 31023 Toulouse (FR); Cassan, Cedric, 31023 Toulouse (FR)
(74) Representative: Hardingham, Christopher Mark

(57) **Abstract**

A radio frequency amplifier device includes four power amplifiers. The first power amplifier output is coupled through a first inductive element to a first signal output terminal and through a second inductive element to a first shunt circuit access terminal. The second power amplifier output is coupled through a third inductive element to the first shunt circuit access terminal. The third power amplifier output is coupled through a fourth inductive element to a second signal output terminal and through a fifth inductive element to a second shunt circuit access terminal. The fourth power amplifier output is coupled through a sixth inductive element to the second shunt circuit access terminal. A first output combiner circuit includes the second and third inductive elements, and a second output combiner circuit includes the fifth and sixth inductive elements. External shunt capacitors are coupled to the first and second shunt circuit access terminals.

## Description

### TECHNICAL FIELD

Embodiments of the subject matter described herein relate generally to power amplifiers, and particularly to power amplifiers implemented in cellular base station transmitters.

### BACKGROUND

A cellular base station enables mobile devices to connect with a cellular network. To provide for two-way communications between the mobile devices and the network, a cellular base station may include multiple radio frequency (RF) transceivers, each of which includes a transmitter path (for transmitting signals from the network to the mobile devices) and a receiver path (for receiving signals from the mobile devices and providing the signals to the network).

A transmitter path of a base station transceiver may include several gain stages (e.g., a pre-driver stage, a driver stage, and a final stage). The physical size of the transmitter path is governed, at least in part, by the design of the gain stages and associated circuitry and packaging (e.g., inter-stage isolators, impedance matching circuits, bias circuitry, heat dissipation structures, and so on).

Because cellular base stations typically are deployed in the outside environment, there is a desire to minimize their size in order to make them less conspicuous. Accordingly, cellular communication system operators desire base stations (and thus base station transceivers) that are as small as possible, while still providing excellent performance. Operators specifically desire base station amplifiers that have smaller form factors, flexibility (e.g., designs that can easily be modified for different frequencies of operation), and low cost (e.g., reduced bill of material (BOM)), among other features. With ever present trends toward miniaturization, cost containment, and flexibility, what are needed are more compact cellular base stations, and particularly more compact base station transceivers and base station transmitters.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 illustrates a cellular radio system that includes multiple transmitters, in accordance with an example embodiment;
FIG. 2 is a schematic drawing of a radio frequency (RF) transmitter, in accordance with an example embodiment;
FIG. 3 is a schematic drawing of an amplification stage that includes a dual 90/0 Doherty power amplifier with tunable output combiner circuits, in accordance with an example embodiment;
FIG. 4 is a top view of an amplification stage that includes a dual 90/0 Doherty power amplifier with tunable output combiner circuits, in accordance with an example embodiment;
FIG. 5 is a top view of an RF amplifier device for use in an amplification stage that includes a dual 90/0 Doherty power amplifier with a tunable output combiner circuit, in accordance with another example embodiment;
FIG. 6 is a schematic drawing of an amplification stage that includes a dual 90/180 Doherty power amplifier with tunable output combiner circuits, in accordance with yet another example embodiment; and
FIG. 7 is a top view of an amplification stage that includes a dual 90/180 Doherty power amplifier with tunable output combiner circuits, in accordance with yet another example embodiment.

### DETAILED DESCRIPTION

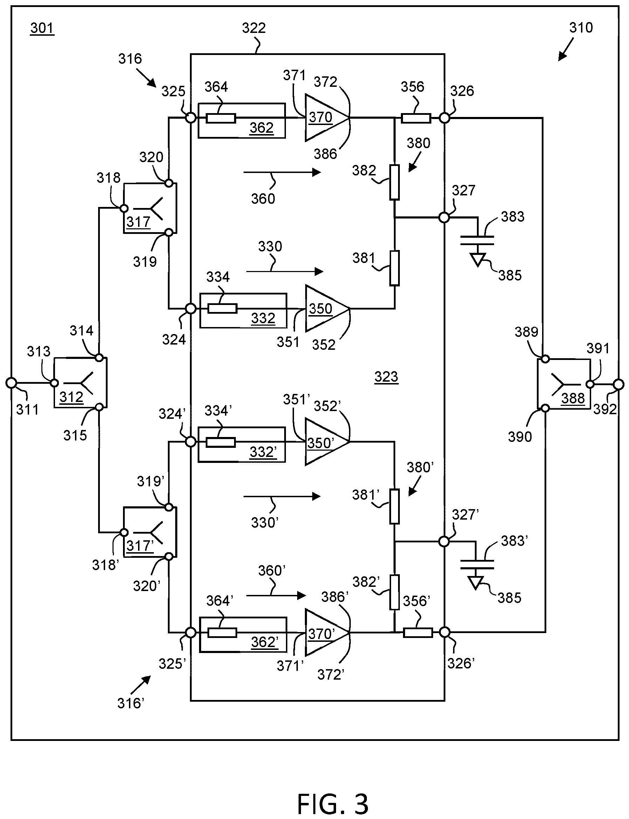

Embodiments of the inventive subject matter include high performing radio frequency (RF) transmitters (e.g., for cellular base stations or other applications) and, more specifically, RF transmitters that are relatively compact and provide for flexibility (e.g., tunability for different operational frequencies). For example, embodiments of RF amplifiers are illustrated and described herein, which include dual Doherty power amplifiers with output combiner circuits that are integrated (e.g., packaged) in such a manner to provide for compactness, while also providing for frequency tunability. These RF amplifiers enable a cellular communications system operator to utilize the same overall transmitter design (e.g., the same transmitter PCB) for amplifiers that operate in different frequency bands by simply changing, on the transmitter PCB, the packaged RF amplifier device (e.g., device 322, 422, 522, 622, 722, FIGs 3-7) and the value of one or more discrete capacitors (e.g., capacitors 383, 383', 483, 483', FIGs 3-7), which are accessible outside of the packaged RF amplifier device.

For example, one or more embodiments of RF amplifiers illustrated and described herein include RF amplifier devices that include multiple amplification paths (e.g., multiple amplification paths of a dual Doherty power amplifier) that are integrated into a same discrete package, along with output combiner circuits that combine the amplified output signals from the multiple amplification paths. As will be described in detail later, certain tuning points within the output combiner circuits are accessible outside of the discrete package, which enables additional circuitry (e.g., tuning capacitors) to be electrically coupled to the output combiner circuits. Essentially, the accessible tuning points enable a similar or same packaged RF amplifier device to be utilized in amplifiers that are designed for different operational frequencies. This tunability enables operators to have substantially the same PCB layout (with a different BOM) for amplifiers designed for different operational frequencies.

According to one or more specific embodiments, an RF amplifier may include multiple Doherty power amplifiers, which may be used in a driver amplification stage and, in some embodiments, in a final amplification stage in a transmitter lineup that includes multiple amplification stages. As will be described in more detail later, when a driver amplification stage is implemented with an embodiment of a dual Doherty power amplifier, the RF amplifier may be designed without an inter-stage isolator between the driver and final amplification stages, which presents a further benefit of the inventive embodiments.

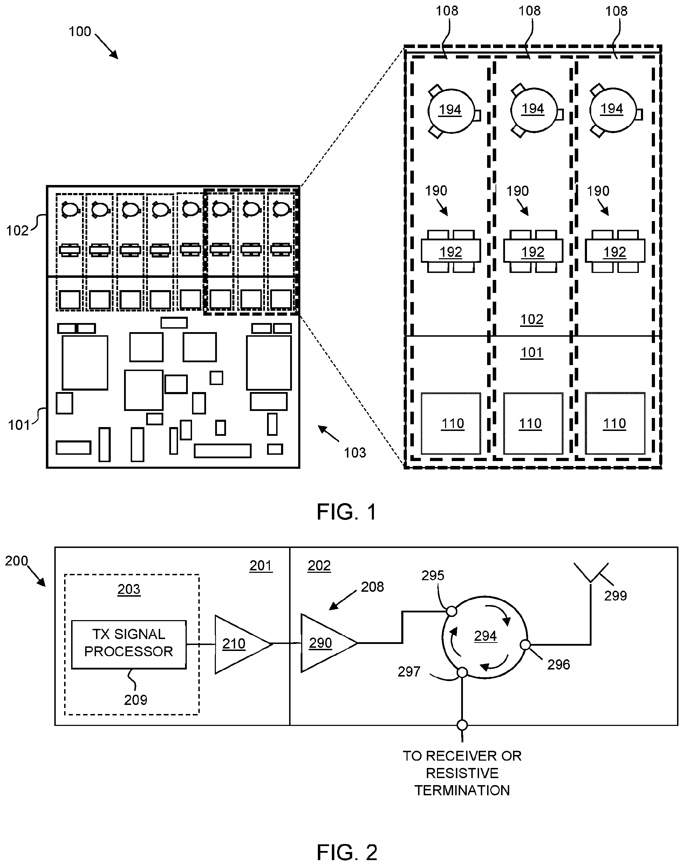

Before describing multiple embodiments of RF transmitters and amplifier devices, embodiments of cellular radio systems (e.g., system 100, FIG. 1) and RF transmitters (e.g., transmitter 200, FIG. 2) will be described to provide context within a cellular communication system (e.g., within a cellular base station). Specifically, FIG. 1 illustrates a cellular radio system 100 that may be included in a cellular base station. The cellular radio system 100 includes transmitter processing circuitry 103 that is designed to interoperate with multiple transmitters 108 (several of which are shown enlarged on the right side of FIG. 1), in accordance with an example embodiment.

Basically, each of the multiple transmitters 108 functions to amplify RF signals received from the transmitter processing circuitry 103, and to provide the amplified RF signals to an antenna (not illustrated) for transmission over the air interface. All of the transmitters 108 in system 100 may be designed to operate within a same operational frequency band, or various ones of the transmitters 108 may be designed to operate within different operational frequency bands.

According to one or more embodiments, the cellular radio system 100 is integrated onto first and second transmitter substrates 101, 102 (e.g., first and second printed circuit boards (PCBs)), which are physically and electrically coupled together. In one or more alternate embodiments, the cellular radio system 100 may be integrated onto a single transmitter substrate.

When implemented onto first and second transmitter substrates 101, 102, the first transmitter substrate 101 may house various transmit baseband processing circuitry, analog-to-digital converters (ADCs), digital-to-analog converters (DACs), frequency up-converters and down-converters, memory components, some circuitry of the transmitter 108 (e.g., driver amplification stage 110), and other circuitry. Because the operational frequencies and power levels of this circuitry and components may be relatively low, the performance of the circuitry and components is not highly affected by the materials used for the first transmitter substrate 101. Accordingly, the first transmitter substrate 101 may be formed from relatively low-cost, low-performance substrate materials (e.g., FR4).

Particular to the inventive embodiments discussed in detail herein, for example, the first transmitter substrate 101 may include one or more driver amplification stages 110 for one or more RF transmitters 108. The driver amplification stages 110 are designed to operate at relatively low power. The driver amplification stage 110 of each transmitter 108 essentially preamplifies an RF transmit signal received from a transmit signal processor on the first transmitter substrate 101, and provides the amplified transmit signal to a final amplification stage 190 on the second transmitter substrate 102.

As will be discussed in detail in conjunction with FIGs 3-7, each driver amplification stage 110 may include features that enable the driver amplification stage 110 to be easily "tuned" for high-efficiency operation within a particular operational frequency band, simply by changing one or more discrete components (e.g., discrete capacitors) that are coupled to the driver amplification stage 110 on the first transmitter substrate 101. This has the advantageous effect of allowing multiple driver amplification stages 110 to have similar or exactly the same layouts on the first transmitter substrate 101, even though the driver amplification stages 110 are coupled to multiple transmitters 108 that are designed for operation at different operational frequencies. In other words, the layout for multiple driver amplification stages 110 may be similar or identical, although different driver stage BOMs may be needed for different operational frequencies. The flexibility of the proposed driver amplification stage 110 is a highly desirable feature for cellular base station operators, and specifically for transmitter designers.

The second transmitter substrate 102 houses transmitter circuitry designed for higher-power and/or higher-frequency operation (in comparison to the circuitry housed on the first transmitter substrate 101). For example, the second transmitter substrate 102 may house a final amplification stage 190 associated with each transmitter 108. Although not covered in detail herein, each final amplification stage 190 may include a high-power amplifier (e.g., a Doherty power amplifier) that is at least partially implemented in a discrete power amplifier device 192 that is coupled to the second transmitter substrate 102. In addition, as will be described in more detail in conjunction with FIG. 2, the second transmitter substrate 102 may house a circulator 194, which is an RF component that is designed to direct amplified RF signals from the final amplification stage 190 to the antenna (not illustrated), and to direct RF signals received from the antenna to receiver circuitry. Generally, the layout (on substrate 102) and BOM are different for final amplification stages 190 that are designed to operate at different operational frequencies.

Because the operational frequencies and power levels of the final amplification stage 190 and the circulator 194 may be relatively high, the performance of these components may be highly affected by the materials used for the second transmitter substrate 102. Accordingly, the second transmitter substrate 102 desirably is formed from relatively high-cost, high-performance (e.g., low loss) RF substrate materials (e.g., RO4350), which are different from the materials used for the first transmitter substrate 101. According to some alternate embodiments, as mentioned above, substantially all of the transmitter circuitry may be implemented on a single transmitter substrate, which desirably is formed from high-performance RF substrate materials.

It may be noted here that a conventional transmitter with a driver amplification stage and a final amplification stage typically includes an interstage RF isolator between the driver and final amplification stages. An interstage RF isolator is a relatively high-cost and large component that is designed to protect RF components from excessive signal reflection. In the present context, for example, an interstage RF isolator could be used to protect sensitive RF circuitry on a first transmitter substrate from higher-power RF signal energy generated within a final amplification stage. However, as will be described in detail later, one or more embodiments of driver amplification stages 110 discussed herein are designed to eliminate the need for an interstage RF isolator between the driver and final amplification stages 110, 190. This provides the beneficial effect of eliminating the need for a transmitter designer to include the additional cost and space that would otherwise be needed for an interstage RF isolator between driver and final amplification stages of an RF transmitter. Elimination of the inter-stage isolator is possible because, as will be discussed in detail later, embodiments of driver amplification stages discussed herein include two Doherty power amplifiers that are combined in quadrature (e.g., dual Doherty power amplifiers).

FIG. 2 is a schematic drawing of an RF transmitter 200 (e.g., any one of transmitters 108, FIG. 1), in accordance with an example embodiment. The RF transmitter 200 includes transmitter processing circuitry 203 (e.g., circuitry 103, FIG. 1), an RF transmitter 208, a circulator 294, and an antenna 299. As mentioned above in conjunction with the description of FIG. 1, according to one or more embodiments, the transmitter processing circuitry 203 and portions of the RF transmitter 208 (e.g., driver amplification stage 210) may be couped to a first transmitter substrate 201 (e.g., substrate 101, FIG. 1). Conversely, the circulator 294 and other portions of the RF transmitter 208 (e.g., final amplification stage 290) may be coupled to a second transmitter substrate 202 (e.g., substrate 202, FIG. 1). Alternatively, all of the amplification circuitry of the RF transmitter may be coupled to a single transmitter substrate.

The RF transmitter 208 (e.g., RF transmitter 108, FIG. 1) may include, for example, a TX signal processor 209 (e.g., a portion of transmitter processing circuitry 103 (FIG. 1), 203) and one or more amplification stages, including a driver amplification stage 210 (or "driver amplifier", e.g., any of amplification stages 110, 310, 410, 610, 710, FIGs 1, 3, 4, 6, and 7) and a final amplification stage 290 (or "final amplifier", e.g., final amplification stage 190, FIG. 1). The transmit signal processor 209 is configured to produce analog transmit signals at RF frequencies, and to provide the transmit signals to the driver amplification stage 210. The driver amplification stage 210 amplifies the transmit signals by applying a first level of gain, and provides the amplified transmit signals to the final amplification stage 290, which further amplifies the transmit signals by applying a second level of gain. The final amplification stage 290 provides the further amplified transmit signals to the antenna 299 through the circulator 294.

In the illustrated embodiment, the RF transmitter 208 is coupled to the antenna 299 through the circulator 294. More specifically, the circulator 294 (e.g., circulator 194, FIG. 1) is a three-port device, with a first port 295 coupled to the RF transmitter 208, a second port 296 coupled to the antenna 299, and a third port 297. When the system 100 is configured to implement Time Division Duplex (TDD) communication for transmit and receive operations, the third port 297 may be coupled to a receiver (not illustrated). Alternatively, when the system 100 is configured to implement Frequency Division Duplex (FDD) communication for transmit and receiver operations, the third port 297 may be coupled to a resistive termination (e.g., a 50 ohm termination, not illustrated).

The circulator 294 is characterized by a signal-conduction directivity, which is indicated by the arrows within the depiction of circulator 294. Essentially, RF signals may be conveyed between the circulator ports 295-296 in the indicated direction (clockwise), and not in the opposite direction (counter-clockwise). Accordingly, during normal operations, signals may be conveyed through the circulator 294 from the first port 295 to the second port 296, and from the second port 296 to the third port 297, but not directly from the first port 295 to the third port 297 or directly from the third port 297 to the second port 296.

As indicated above, the driver amplification stage 110, 210 (FIGs 1, 2) of an RF transmitter 108, 208 (FIGs 1, 2) may include various embodiments of Doherty power amplifiers. Further, one or more embodiments of a driver amplification stage 110, 210 (FIGs 1, 2) may include features that enable the driver amplification stage to be easily "tuned" for high-efficiency operation within a particular operational frequency band, simply by changing one or more discrete components (e.g., discrete capacitors) that are coupled to the driver amplification stage.

As will be described in detail below in conjunction with FIGs 3-7, substantial portions of the Doherty power amplifiers for a driver amplification stage may be implemented in a packaged amplifier device (e.g., devices 322, 422, 622, 722, FIGs 3-7), and embodiments of output combiner circuits (e.g., circuits 380, 380', 480, 480', 580, 580', 680, 680', 780, 780', FIGs 3-7) of those Doherty power amplifiers include access points (e.g., shunt circuit access terminals 327, 327', 427, 427', 527-1, 527-2, 527-1', 527-2', FIGs 3-7) that enable tuning components (e.g., capacitors 383, 383', 483, 483', FIGs 3-7) to be electrically coupled to the output combiner circuits. The values of the tuning components (e.g., the capacitance values) may be selected to "tune" each Doherty power amplifier for high-performance operation at various operational frequencies. In other words, when a tuning component includes a first capacitor with a first capacitance value, inclusion of that first capacitor in an output combiner circuit may tune the Doherty power amplifier for high-performance operation within a first operational frequency band (e.g., 1805-1880 megahertz (MHz)). Conversely, when a tuning component includes a second capacitor with a second capacitance value, inclusion of that second capacitor in an output combiner circuit may tune the Doherty power amplifier for high-performance operation within a second and different operational frequency band (e.g., 2110-2170 MHz). Again, this has the advantageous effect of allowing each of multiple transmitters (e.g., transmitters 108, FIG. 1) to have a similar or exactly the same layout, even though the multiple transmitters 108 may be tuned to operate at different operational frequencies.

Various embodiments of amplification stages that may be particularly well suited for use as a driver amplification stage (e.g., amplification stages 110, 210, FIGs 1, 2) in an RF transmitter of a cellular base station transmitter will now be described in conjunction with FIGs 3-7. It should be noted here that the embodiments of amplification stages illustrated and described herein may be used in contexts other than as a driver amplification stage in a cellular base station transmitter (e.g., the various embodiments may be used in systems other than cellular base station transmitters, and/or the various embodiments may be used in other stages of a transmitter lineup). Accordingly, implementation of the various embodiments is not limited to use in a cellular base station transmitter, and more particularly, is not limited to use as a driver amplification stage.

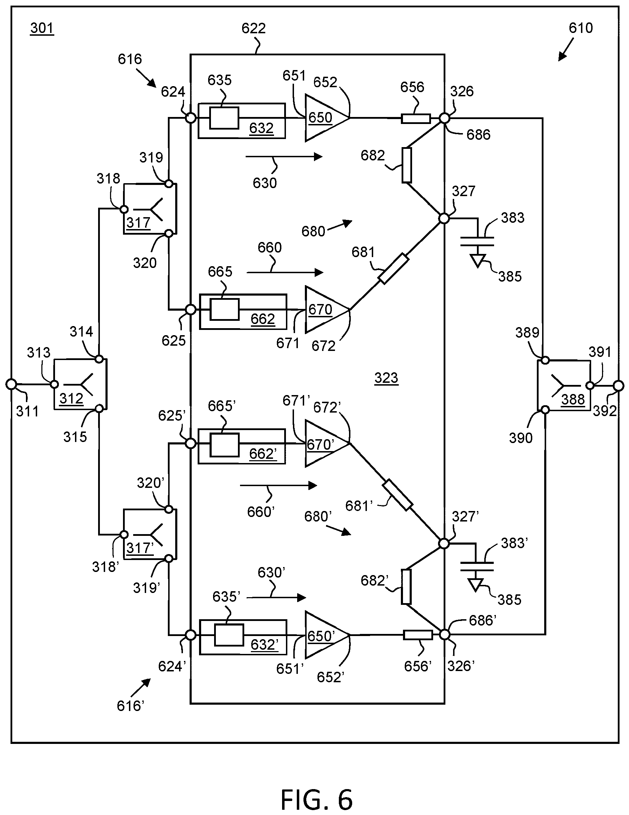

It is noted here that, for the convenience and understandability of the reader, components or circuits in the various drawings that correspond to exactly the same thing have identical reference numbers (e.g., power amplifier 350 in FIG. 3 is the same as power amplifier 350 in FIG. 6). For brevity, the entirety of the description of characteristics of a particular component or circuit may not be repeated verbatim in the descriptions of all figures in which the component is included. However, it is to be understood that, when the characteristics of a component or circuit with a particular reference number is described in detail in conjunction with the description of a particular figure (e.g., power amplifier 350 in FIG. 3), the described details are incorporated by reference into the description of the same-numbered component or circuit in conjunction with a different figure (e.g., power amplifier 350 in FIG. 6).

Further, components or circuits in the various drawings that correspond to different embodiments of a component or circuit ("analogous components") may be identified with similar reference numbers that have the same last two digits. For example, analogous components identified by similar reference numbers 322, 422, 422', 622, 722 in FIGs 3-7 each correspond to different embodiments of a packaged amplifier device. Again, for brevity, to the extent that characteristics of analogous components or circuits are the same in different figures, those characteristics may not be repeated verbatim in the descriptions of all figures in which the analogous components are included. Instead, the descriptions may focus on the differences between characteristics of the analogous components. However, it is to be understood that, when characteristics of analogous components or circuits with reference numbers having the same last two digits are described in detail in conjunction with the description of a particular figure (e.g., packaged amplifier device 322 in FIG. 3), as long as differences are not specifically identified, the described details are incorporated by reference into the description of the similarly-numbered component or circuit in conjunction with a subsequent figure (e.g., packaged amplifier device 622 in FIG. 6).

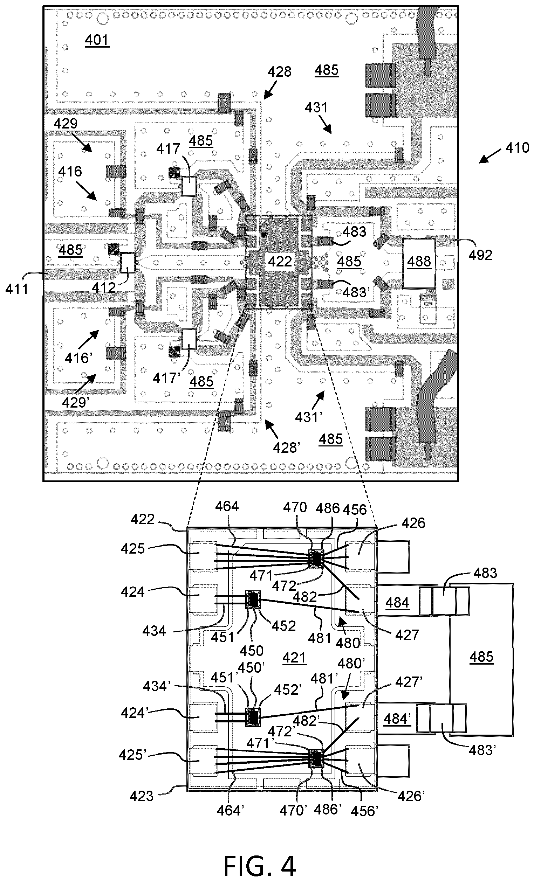

FIG. 3 is a schematic drawing of an amplification stage 310 (e.g., amplification stage 110, 210, FIGs 1, 2) that includes a dual 90/0 Doherty power amplifier with tunable output combiner circuits, in accordance with an example embodiment. For enhanced understanding, FIG. 3 should be viewed simultaneously with FIG. 4, which is a top view of a physical implementation of an amplification stage 410 that includes the dual 90/0 Doherty power amplifier of FIG. 3.

Some terminology may be useful at this point. In particular, the term "dual Doherty power amplifier" means an amplifier that includes two Doherty power amplifiers (e.g., amplifiers 316, 316', FIG. 3, or 416, 416', FIG. 4) that are implemented in parallel with each other in an amplification circuit. Further, the term "90/0 Doherty power amplifier" means a Doherty power amplifier that has an output combining circuit (e.g., circuits 380, 380', 480, 480', FIGs 3, 4) in which an electrical length between the output of one amplifier or amplifier die (e.g., amplifier 350 or amplifier die 450, FIGs 3, 4) and a combining node (e.g., combining node 386, 386', 486, 486', FIGs 3, 4) is about 90 degrees (i.e., exactly 90 degrees or between about 85 and 95 degrees), and in which an electrical length between the output of another amplifier or amplifier die (e.g., amplifier 370 or amplifier die 470, FIGs 3, 4) and a combining node (e.g., combining node 386, 386', 486, 486', FIGs 3, 4) is about zero degrees (although there may be a minimal electrical length).

Referring now to FIGs 3 and 4, an amplification stage 310, 410 includes various circuitry and devices housed on a transmitter substrate 301, 401 (e.g., transmitter substrate 101, 201, FIGs 1, 2). As mentioned above, the amplification stage 310, 410 may correspond to a driver amplification stage (e.g., amplification stages 110, 210, FIGs 1, 2) in an RF transmitter of a cellular base station transmitter, although the amplification stage 310, 410 is not limited to that particular application or location along a transmitter lineup.

The amplification stage 310, 410 essentially includes a dual 90/0 Doherty power amplifier coupled to the transmitter substrate 301, 401, which includes a first Doherty power amplifier 316, 416 and a second Doherty power amplifier 316', 416' arranged in parallel (e.g., in quadrature). More particularly, amplification stage 310, 410 includes a transmitter input terminal 311, 411, a first signal power splitter 312, 412, the first Doherty power amplifier 316, 416, the second Doherty power amplifier 316', 416', a signal power combiner 388, 488, and a transmitter output terminal 392, 492.

The first signal power splitter 312, 412 is physically coupled to the transmitter substrate 301, 401. The first signal power splitter 312, 412 may have any of a variety of configurations. For example, the first signal power splitter 312, 412 may be a splitter selected from a Wilkinson-type splitter, a hybrid quadrature splitter, or another suitable type of splitter. Either way, the first signal power splitter 312, 412 has a first splitter input terminal 313, a first splitter output terminal 314, and a second splitter output terminal 315. Although not indicated in FIG. 3 (but as shown in FIG. 4), the first signal power splitter 312, 412 also may include an additional terminal that is coupled through a resistive termination to a ground reference (e.g., ground reference 485, FIG. 4) of the transmitter substrate 301, 401. For example, the ground reference 485 if the transmitter substrate 301, 401 may be a conductive ground plane embedded within the transmitter substrate 301, 401.

The first splitter input terminal 313 is electrically coupled through a conductive trace on substrate 301, 401 to the transmitter input terminal 311, 411, and is configured to receive an input RF signal for amplification (e.g., an input RF signal from TX signal processor 209, FIG. 2). The first splitter output terminal 314 is electrically coupled through another conductive trace on substrate 301, 401 to an input to the first Doherty power amplifier 316, 416. In the illustrated embodiment, the input to the first Doherty power amplifier 316, 416 corresponds to an input terminal 318 of a second signal power splitter 317, 417. Similarly, the second splitter output terminal 315 is electrically coupled through yet another conductive trace on substrate 301, 401 to an input to the second Doherty power amplifier 316', 416'. In the illustrated embodiment, the input to the second Doherty power amplifier 316', 416' corresponds to an input terminal 318' of a second signal power splitter 317', 417'.

The first splitter input terminal 313 is configured to receive, at input terminal 313, an input RF signal from RF input 311, and to divide the power of the input RF signal into first and second RF input signals. The first signal power splitter 312, 412 divides the power of the input RF signal such that about half of the input RF signal power is provided to the first splitter output terminal 314 (and thus to the first Doherty power amplifier 316, 416), and about half of the input RF signal power is provided to the second splitter output terminal 315 (and thus to the second Doherty power amplifier 316', 416').

Details of the dual 90/0 Doherty power amplifier (e.g., amplification stage 310, 410) will be described in detail later. Briefly, each of the first and second Doherty power amplifiers 316, 316', 416, 416' of the dual 90/0 Doherty power amplifier is electrically coupled between the first signal power splitter 312, 412 and a signal power combiner 388, 488. The signal power combiner 388, 488 is physically coupled to the transmitter substrate 301, 401. As with the first signal power splitter 312, the signal power combiner 388, 488 may have any of a variety of configurations. For example, the signal power combiner 388, 488 may be a combiner selected from a Wilkinson-type combiner, a hybrid quadrature combiner, or another suitable type of combiner. Either way, the signal power combiner 388, 488 has a first combiner input terminal 389, a second combiner input terminal 390, and a combiner output terminal 391. Although not indicated in FIG. 3 (but as shown in FIG. 4), the signal power combiner 388, 488 also may include an additional terminal that is coupled through a resistive termination to a ground reference (e.g., ground reference 485, FIG. 4) of the transmitter substrate 301, 401.

The first combiner input terminal 389 is electrically coupled through yet another conductive trace on substrate 301, 401 to an output of the first Doherty power amplifier 316, 416 (e.g., to terminal 326). A first amplified RF output signal from the first Doherty power amplifier 316, 416 is received at the first combiner input terminal 389. Similarly, the second combiner input terminal 390 is electrically coupled through yet another conductive trace on substrate 301, 401 to an output of the second Doherty power amplifier 316', 416' (e.g., to terminal 326'). A second amplified RF output signal from the second Doherty power amplifier 316', 416' is received at the second combiner input terminal 390. The signal power combiner 388, 488 is configured to combine the power of the first and second amplified RF output signals into a third amplified RF output signal, which is provided at the combiner output terminal 391. The combiner output terminal 391 is electrically coupled through yet another conductive trace on substrate 301, 401 to the transmitter output terminal 392, 492, and accordingly, the third amplified RF output signal is provided to the transmitter output terminal 392, 492.

As the above description indicates, of the dual 90/0 Doherty power amplifier (i.e., amplification stage 310, 410) basically has two parallel amplification paths (i.e., the first and second Doherty power amplifiers 316, 316', 416, 416'). The power of an input RF signal provided at an input 311, 411 to the amplification stage 310, 410 (at input 311, 411) is equally divided (by the first power splitter 312, 412) into first and second RF input signals, which are separately amplified through the parallel amplification paths. The resulting first and second amplified RF output signals are then combined (by the signal power combiner 388, 488), and provided as the third amplified RF output signal at the transmitter output terminal 392, 492 of the amplification stage 310, 410.

The first and second Doherty power amplifiers 316, 316', 416, 416' will now be described in more detail. According to one or more embodiments, the first and second Doherty power amplifiers 316, 316', 416, 416' may be implemented using substantially the same circuit configuration (e.g., the same components electrically coupled together in the same manner). Generally, each of the first and second Doherty power amplifiers 316, 316', 416, 416' has some circuitry ("external circuitry") that is directly physically connected to the first transmitter substrate 301, 401, and other circuitry ("internal circuitry") that is housed within an RF amplifier device 322, 422. The RF amplifier device 322, 422 is directly physically connected to the mounting surface of the first transmitter substrate 301, 401. In other words, the RF amplifier device 322, 422 is a discrete, surface-mount component. As will be described in detail below, the "external circuitry" that is directly connected to the first transmitter substrate 301, 401 electrically communicates with the "internal circuitry" that is housed within the RF amplifier device 322, 422 through various device terminals.

Before describing additional details of the circuitry of the first and second Doherty power amplifiers 316, 316', 416, 416', the structure of the RF amplifier device 322, 422 will first be described. According to one or more embodiments, the RF amplifier device 322, 422 includes a discrete package body 323, 423. According to one or more embodiments, the discrete package body 323, 423 includes a conductive flange 421 and a plurality of conductive device terminals 324, 324', 325, 325', 326, 326', 327, 327', 424, 424', 425, 425', 426, 426', 427, 427', which are held in a fixed physical relationship by rigid non-conductive material of the discrete package body 323, 423 (e.g., by ceramic or plastic encapsulation).

It should be mentioned here that, although FIG. 4 depicts a certain type of package body 323, 423 and a certain type of device terminals 324-327, 324'-327', 424-427, 424'-427', the RF amplifier device 322, 422 may have any of a variety of form factors. For example, the RF amplifier device 322, 422 may include a surface-mount type of package body 323, 423, in some embodiments, or may include a through-hole type of package body 323, 423, in other embodiments. Surface-mount types of package bodies 323, 423 may include, for example, flat packages (e.g., dual flat packages or quad flat packages), chip-scale packages, ball grid arrays, pin grid arrays, leaded or leadless chip carriers, or other types of packages. In some other embodiments, the package body 323, 423 may include a small multi-layer PCB, where the device terminals may include through substrate vias that contact conductive pads on the bottom of the PCB. Each of the device terminals 324-327, 324'-327', 424-427, 424'-427' has a form factor that is appropriate for the type of package body 323, 423. For example, each of the device terminals 324-327, 324'-327', 424-427, 424'-427' may be "leadless" terminals that do not extend beyond the package body 323, 423. Alternatively, each of the device terminals 324-327, 324'-327', 424-427, 424'-427' may be "leaded" terminals (e.g., gull-wing terminals) that extend beyond the package body 323, 423. For purposes of illustration and not by way of limitation, FIG. 4 shows an RF amplifier device 422 with a dual flat package (DFP) configuration.

More specifically, the discrete package body 323, 423 includes a central conductive flange 421 and a plurality of device terminals 324-327, 324'-327', 424-427, 424'-427', all of with are embedded in non-conductive material (e.g., ceramic or plastic encapsulant). A component mounting surface of the conductive flange 421 and "proximal ends" of the device terminals 324-327, 324'-327', 424-427, 424'-427' are exposed within an interior of the package body 323, 423. As will be described in more detail below, various electrical components are physically and electrically coupled to a mounting surface of the conductive flange 423, and are electrically coupled to the proximal ends of the device terminals 324-327, 324'-327', 424-427, 424'-427' through wirebonds or other conductors. A non-conductive cover may enclose the electrical components and wirebonds in an air cavity, in some embodiments. In other embodiments, the electrical components and wirebonds may be covered with a non-conductive encapsulant material (e.g., plastic encapsulant). In FIG. 4, the upper image showing RF amplifier device 422 mounted to the transmitter substrate 401 shows a top surface of the RF amplifier device 422, which is defined by an outer surface of the non-conductive cover or the non-conductive encapsulant material, which obscures the internal circuitry. For improved visibility, the lower image in FIG. 4 shows an enlarged image of the RF amplifier device 422, with the cover or non-conductive encapsulant material removed so that the internal circuitry can be seen.

An outer surface of the conductive flange 421 and "distal ends" of the device terminals 324-327, 324'-327', 424-427, 424'-427' are exposed at an exterior of the package body 323, 423 (e.g., at a bottom surface of the package body 323, 423). The conductive flange 421 may function as a ground reference and/or heat dissipation structure for at least some of the electrical components within the device 322, 422, and the exposed outer surface of the conductive flange 421 enables the interior circuitry to be electrically and thermally coupled to additional conductive structures of the transmitter substrate 301, 401 (not shown, but located directly underneath device 422). Additionally, the distal ends of the device terminals 324-327, 324'-327', 424-427, 424'-427' are physically and electrically coupled (e.g., through solder or other conductive connections) to conductive pads or traces (not numbered) at the top surface of the transmitter substrate 301, 401. In this manner, the external circuitry of each Doherty power amplifier 316, 316', 416, 416' may be electrically connected to the internal circuitry (within device 322, 422) of each Doherty power amplifier 316, 316', 416, 416' through the device terminals 324-327, 324'-327', 424-427, 424'-427'.

As will be discussed in more detail below, each Doherty power amplifier 316, 316', 416, 416' includes a carrier amplifier 350, 350', 450, 450' and a peaking amplifier 370, 370', 470, 470'. According to one or more embodiments, each carrier and peaking amplifier is implemented with a power transistor integrated within a power transistor semiconductor die coupled to the mounting surface of the conductive flange 421 of the package body 323, 423. For example, carrier amplifiers 350, 350' (FIG. 3) may be physically implemented with carrier amplifier dies 450, 450' (FIG. 4), and peaking amplifiers 370, 370' (FIG. 3) may be physically implemented with peaking amplifier dies 470, 470' (FIG. 4). For example, each of the power transistor(s) within each of the amplifier dies 450, 450', 470, 470' may be a field effect transistor (FET), such as a laterally-diffused metal oxide semiconductor (LDMOS) FET or a high electron mobility transistor (HEMT). The description may refer to each transistor as including an amplifier input terminal 351, 351', 371, 371', 451, 451', 471, 471', a first amplifier output terminal 352, 352', 372, 372', 452, 452', 472, 472', and a second amplifier output terminal (not numbered). For example, using terminology associated with FETs, an "amplifier input terminal" refers to a gate terminal of a transistor, a "first amplifier output terminal" refers to a drain terminal of the transistor, and a "second amplifier output terminal" refers a source terminal of the transistor. Although the below description may use terminology commonly used in conjunction with FET devices, the various embodiments are not limited to implementations the utilize FET devices, and instead are meant to apply also to implementations that utilize bipolar junction transistors (BJT) devices or other suitable types of transistors.

In some embodiments, each carrier amplifier die 450, 450' and peaking amplifier die 470, 470' more specifically includes a gallium nitride (GaN) HEMT. In other embodiments, each of the carrier amplifier die 450, 450' and peaking amplifier die 470, 470'may include silicon-based power transistors, or power transistors formed using other semiconductor technologies (e.g., silicon germanium (SiGe) and/or gallium arsenide (GaAs)).

The first Doherty power amplifier 316, 416 of the dual 90/0 Doherty power amplifier includes an RF input (e.g., corresponding to an input terminal 318 of splitter 317, 417), an RF output (e.g., corresponding to a first output terminal 326, 426 of device 322, 422), a signal splitter 317, 417 (referred to herein as a "second signal splitter"), a carrier amplification path 330, a peaking amplification path 360, and an output combiner circuit 380. The first amplifier input terminal 324 corresponds to an input terminal for the carrier amplification path 330, and the second amplifier input terminal 325 corresponds to an input terminal for the peaking amplification path 360.

Similarly, the second Doherty power amplifier 316', 416' of the dual 90/0 Doherty power amplifier includes an RF input (e.g., corresponding to an input terminal 318' of splitter 317', 417'), an RF output (e.g., corresponding to a second output terminal 326', 426' of device 322, 422), a signal splitter 317' 417' (referred to herein as a "third signal splitter"), a carrier amplification path 330', a peaking amplification path 360', and an output combiner circuit 380'. The third amplifier input terminal 324' corresponds to an input terminal for the carrier amplification path 330', and the fourth amplifier input terminal 325' corresponds to an input terminal for the peaking amplification path 360'.

Briefly, during operation of the dual 90/0 Doherty power amplifier, within each of the first and second Doherty power amplifiers 316, 316', 416, 416', the power of an input RF signal (e.g., the first or second RF signals produced at output terminals 314, 315, respectively, of the first signal power splitter 312, 412) is provided at an RF input (e.g., splitter input terminal 318 or 318') to the first or second Doherty power amplifier 316, 316', 416, 416'. Each of the second and third signal splitters 317, 317', 417, 417' divides the power of the first or second RF signal (produced at output terminals 314, 315 of splitter 312, 412) into a carrier RF signal and a peaking RF signal. Each carrier RF signal is amplified along the carrier amplification path 330, 330', and each peaking RF signal is amplified along the peaking amplification path 360, 360'. The amplified carrier and peaking RF signals produced by the carrier and peaking amplifiers 350, 350', 370, 370' are then combined through an output combining circuit 380, 380'. A resulting first or second amplified RF output signal is then conveyed through an output terminal 326, 326', 426, 426' of the device 322, 422 and through a conductive trace on the transmitter substrate 301, 401 to a first or second combiner input 389, 390 of the signal power combiner 388, 488. The signal power combiner 388, 488 then combines the power of the first and second amplified RF output signals, and produces a combined amplified RF output signal at combiner output 391. The combined amplified RF output signal is then conveyed from combiner output 391 to the transmitter output terminal 392, 492 through another conductive trace on the transmitter substrate 301, 401.

When incorporated into a larger system (e.g., a transmitter 200 of a cellular radio system 100 (FIGs 1, 2)), the transmitter output terminal 392, 492 is electrically coupled to the input to a final stage amplifier (e.g., amplifier 190, 290, FIGs 1, 2). The output of the final stage amplifier (e.g., amplifier 190, 290, FIGs 1, 2), in turn, is coupled to a load. For example, as discussed in conjunction with FIGs 1 and 2, the load may include a circulator (e.g., circulator 194, 294, FIGs 1, 2) and an antenna (e.g., antenna 299, FIG. 2), or another type of load.

Each Doherty power amplifier 316, 316', 416, 416' is considered to be a "two-way" Doherty power amplifier, which includes one carrier amplification path 330, 330' and one peaking amplification path 360, 360'. In other embodiments, each Doherty power amplifier 316, 316', 416, 416' may include one or more additional peaking amplification paths (not shown) in parallel with peaking amplification path 360, 360'.

Further, in various embodiments, each Doherty power amplifier 316, 316', 416, 416' may be a "symmetric" or an "asymmetric" amplifier. When a Doherty power amplifier 316, 316', 416, 416' is a "symmetric" amplifier, the relative sizes of the carrier and peaking amplifiers 350, 350', 370, 370' (i.e., the size of dies 450, 450', 470, 470') are approximately equal to each other. Conversely, when a Doherty power amplifier 316, 316', 416, 416' is an "asymmetric" amplifier, the relative sizes of the carrier and peaking amplifiers 350, 350', 370, 370' (i.e., the size of dies 450, 450', 470, 470') are different from each other. Typically, in an asymmetric Doherty power amplifier, the peaking amplifier 370, 370' is larger than the carrier amplifier 350, 350'.

More specifically, as used herein, the term "size," when referring to a physical characteristic of a power amplifier or power transistor, refers to the periphery or the current carrying capacity of the transistor(s) associated with that amplifier or transistor. The term "symmetric," when referring to the relative sizes of carrier and peaking amplifiers 350, 350' and 370, 370', means that the size of the power transistor(s) within the carrier amplifier dies 450, 450' is/are substantially identical to (i.e., within 5%) the size of the power transistor(s) within the peaking amplifier dies 470, 470'. Conversely, the term "asymmetric" means that the size of the power transistor(s) within the carrier amplifier dies 450, 450' is/are significantly different from the size of the power transistor(s) within the peaking amplifier dies 470, 470' (e.g., the size of the power transistor(s) within the peaking amplifier dies 470, 470' is/are from 50% to 100% or more than the size of the power transistor(s) within the carrier amplifier dies 450, 450'). Accordingly, for example, when the ratio of carrier amplifier size to peaking amplifier size (or the "carrier-to-peaking ratio") is denoted as *x*:*y* (where *x* corresponds to relative carrier amplifier size and *y* corresponds to relative peaking amplifier size), a ratio of 1:1 would be symmetric, and a ratio of 1:2 would be asymmetric, according to the above definitions.

The configuration of each Doherty power amplifier 316, 316', 416, 416' will now be discussed in more detail. In each Doherty power amplifier 316, 316', 416, 416', the RF input (e.g., the input terminal 318 of the signal splitter 317, 417 or the input terminal 318' of the signal splitter 3 18', 421') is configured to receive either the first or the second input RF signal from the first signal splitter 312, 412 (i.e., from the first signal splitter output terminal 314 or from the second signal splitter output terminal 315).

The second and third signal power splitters 317, 317', 417, 417' are physically coupled to the transmitter substrate 301, 401. The second and third signal splitters 317, 317', 417, 417' may have any of a variety of configurations. For example, each of signal splitters 317, 317', 417, 417' may be a splitter selected from a Wilkinson-type splitter, a hybrid quadrature splitter, or another suitable type of splitter. Either way, each signal splitter 317, 317', 417, 417' has an input 318, 318' coupled to an output terminal 314, 315 of the first signal splitter 312, and two outputs 319, 319', 320, 320'. Although not indicated in FIG. 3 (but as shown in FIG. 4), each of the second and third signal splitters 317, 317', 417, 417' also may include an additional terminal that is coupled through a resistive termination to a ground reference (e.g., ground reference 485, FIG. 4) of the transmitter substrate 301, 401.

A first signal splitter output 319, 319' is coupled to the carrier amplification path 330, 330' through a conductive trace on the transmitter substrate 301, 401 and through the first or third amplifier input terminal 324, 324'. A second signal splitter output 320, 320' is coupled to the peaking amplification path 370, 370' through another conductive trace on the transmitter substrate 301, 401 and through the second or fourth amplifier input terminal 325, 325'. Essentially, each signal splitter 317, 317', 417, 417' is configured to receive, at its input 318, 318', one of the first or second RF input signals from the first signal splitter 312, 412, and to divide the power of the received input RF signal into a carrier RF signal and a peaking RF signal. Each signal splitter 317, 317', 417, 417' is further configured to provide, at the first signal splitter output 319, 319', the carrier RF signal for the carrier amplification path 330, 330', and to provide, at the second signal splitter output 320, 320', the peaking RF signal for the peaking amplification path 360, 360'.

Proper operation of a Doherty power amplifier requires the carrier RF signal to be about 90 degrees out of phase with the peaking RF signal when those signals arrive at the inputs 351, 351', 371, 371' to the carrier and peaking amplifiers 350, 350', 370, 370', respectively. This 90 degree phase difference is implemented at the input to the Doherty power amplifier in order to compensate for a 90 degree phase shift applied at the output of the Doherty power amplifier (e.g., a 90 degree phase shift applied by output combiner circuit 380, 380', 480, 480'), as will be discussed later. In some embodiments (e.g., when hybrid quadrature splitters are used), the first and second signal splitters 317, 317', 417, 417' are configured to produce a peaking RF signal at the second signal splitter output 320, 320' that is about 90 degrees out of phase from (e.g., delayed from) the carrier RF signal produced at the first signal splitter output 319, 319'. In other embodiments (e.g., when Wilkinson-type splitters are used), the first and second signal splitters 317, 317', 417, 417' are configured to produce carrier and peaking RF signals at the first and second signal splitter outputs 319, 319', 320, 320' that are in phase with each other, and the above-mentioned 90 degree phase difference between the carrier and peaking RF signals may be imparted through a first series of conductive elements (described below) between the second signal splitter output 320, 320' and the peaking amplifier 370, 370'.

During operation of the amplification stage 310 in a relatively low-power mode (i.e., when the power of the input RF signal is below a threshold), only the carrier amplification paths 330, 330' supply current to the load (through amplifier output terminals 326, 326', 426, 426'). In such circumstances, the RF signal level at the peaking amplifier input terminal 325, 325', is below the threshold to turn on the peaking amplifier 370, 370'. Thus, the combined power from the carrier and peaking amplifiers 350, 350', 370, 370' is substantially from the carrier amplification path 330, 330'. Conversely, during operation of the amplification stage 310 in a relatively high-power mode (i.e., when the power of the input RF signal is above a threshold), both the carrier and peaking amplification paths 330, 330', 360, 360' supply current to the load. In such circumstances, the RF signal level at the peaking amplifier input terminal 325, 325' is above the threshold to turn on the peaking amplifier 370, 370'. Thus, both the carrier and peaking amplifier paths 330, 330', 360, 360' contribute to the combined power.

Each of the second and third signal splitter 317, 317' divides the power of the input RF signal according to a carrier-to-peaking size ratio. For example, when Doherty power amplifier 316, 316' has a symmetric configuration in which the carrier amplifier 350, 350' and the peaking amplifier 370, 370' are substantially equal in size (i.e., the Doherty power amplifier 316, 316' has a 1:1 carrier-to-peaking size ratio), each of the second and third signal splitter 317, 317' may divide the power of the input RF signal such that about half of the input RF signal power is provided to the carrier amplification path 330, 330', and about half of the input RF signal power is provided to the peaking amplification path 360, 360'. Conversely, when Doherty power amplifier 316, 316' has an asymmetric configuration (e.g., the Doherty power amplifier 316, 316' has a 1:x carrier-to-peaking size ratio, where x > 1), each of the second and third signal splitter 317, 317' may divide the power unequally. For example, when Doherty power amplifier 316, 316' has a 1:2 carrier-to-peaking size ratio, each of the second and third signal splitter 317, 317' may divide the power of the input RF signal such that a third of the input signal power is provided to the carrier amplification path 330, 330', and two thirds of the input signal power is provided to the peaking amplification path 360, 360'.

In addition, as mentioned above, the peaking input RF signal should be about 90 degrees out of phase with (delayed from) the carrier input RF signal when those signals arrive at the inputs 351, 351', 371, 371' to the carrier and peaking amplifiers 350, 350', 370, 370', respectively. In embodiments in which the signal splitter 317, 317' is configured to produce carrier and peaking input RF signals that are 90 degrees out of phase with each other (e.g., when hybrid quadrature splitters are used), the phase shift applied along the carrier amplification path 330, 330' between the first signal splitter output 319, 319' and the carrier amplifier input 351, 351' may be about equal to the phase shift applied along the peaking amplification path 360, 360' between the second splitter output 320, 320' and the peaking amplifier input 371, 371'. Conversely, when the signal splitter 317, 317' is not configured to produce carrier and peaking input RF signals that are 90 degrees out of phase with each other (e.g., when Wilkinson-type splitters are used), the phase shift applied along the peaking amplification path 360, 360' between the second signal splitter output 320, 320' and the peaking amplifier input 371, 371'may be 90 degrees greater than the phase shift applied along the carrier amplification path 330, 330' between the first splitter output 319, 319' and the carrier amplifier input 351, 351'. The additional 90 degrees of phase shift along the peaking amplification path 360, 360' may be achieved on the transmitter substrate 301, 401 through a longer conductive trace (e.g., a conductive trace that is 90 degrees longer) between the second signal splitter output 320, 320' and the second or fourth amplifier input terminal 325, 325' than the conductive trace between the first signal splitter output 319, 319' and the first or third amplifier input terminal 324, 324'. Alternatively, the additional 90 degree delay along the peaking amplification path 360, 360' may be achieved using internal circuitry within the device 322, 422.

The carrier amplification path 330, 330' is coupled between the first splitter output 319, 319' and a combining node 386, 386', 486, 486' of the output combiner circuit 380, 380', 480, 480'. Each carrier amplification path 330, 330' includes, a series of conductive elements between the first splitter output 319, 319' and the carrier amplifier 350, 350', 450, 450', the carrier amplifier 350, 350', 450, 450', and inductive elements 381, 381', 382, 382', 481, 481', 482, 482' of a phase shift and impedance inversion circuit within the output combiner circuit 380, 380', 480, 480'. The series of conductive elements of the carrier amplification path 330, 330' includes: 1) a conductive trace (not numbered) on the transmitter substrate 301, 401 between the first splitter output 319, 319' and the first or third amplifier input terminals 324, 324', 424, 424'; 2) one of the first or third amplifier input terminals 324, 324', 424, 424' of the device 322, 422; and 3) an inductive element 334, 334' (e.g., one or more wirebonds 434, 434') within the device 322, 422 between the first or third amplifier input terminal 324, 324', 424, 424' and the carrier amplifier 350, 350'.

Distal ends of the first and third amplifier input terminals 324, 324', 424, 424' are coupled (e.g., soldered) to ends of the conductive traces (or to conductive pads) on the transmitter substrate 301, 401. Each inductive element 334, 334', 434, 434' provides an electrical connection between one of the first and third amplifier input terminals 324, 324', 424, 424' and an input 351, 351', 451, 451' to the carrier amplifier 350, 350', 450, 450'. As shown in FIG. 4, each inductive element 334, 334' may be implemented as one or more wirebonds 434, 434' between the first or third amplifier input terminals 324, 324', 424, 424' and the input 351, 351', 451, 451' to the carrier amplifier 350, 350', 450, 450'. In addition, the inductive element 334, 334', 434, 434' may form a portion of an optional carrier IMN 332, 332'. When included, the carrier IMN 332, 332' is configured to incrementally increase the circuit impedance. For example, but not by way of limitation, the carrier IMN 332, 332' may include, for example, a lowpass or bandpass circuit configured as a T- or pi- impedance matching network, where the inductive element 334, 334', 434, 434' provides a series inductance in the circuit.

As mentioned above, each carrier amplifier 350, 350' may be implemented as a power transistor in a carrier amplifier die 450, 450', which is physically and electrically coupled to the conductive flange 421 of the package body 323, 423. As used herein, "carrier amplifier" and "carrier amplifier die" may be used interchangeably. Each carrier amplifier 350, 350', 450, 450' has a carrier amplifier input 351, 351', 451, 451' (e.g., a gate terminal) and two current-carrying terminals (e.g., drain and source terminals). As indicated above, the carrier amplifier input 351, 351', 451, 451' is coupled through inductive element 334, 334', 434, 434' (and/or through the carrier IMN 332, 332') to the first or third amplifier input terminal 324, 324'. One of the current-carrying terminals (e.g., the drain terminal) of the carrier amplifier 350, 350', 450, 450' functions as a carrier amplifier output 352, 352', 452, 452', at which an amplified carrier signal is produced by the carrier amplifier 350, 350', 450, 450'. The other current-carrying terminal (e.g., the source terminal) of the carrier amplifier 350, 350', 450, 450' may be coupled to a ground reference node (e.g., to the conductive flange 421).

The carrier amplifier 350, 350', 450, 450' is configured to amplify the carrier input RF signal received at the carrier amplifier input 351, 351', 451, 451', and to produce an amplified carrier signal at the carrier amplifier output 352, 352', 452, 452'. The output 352, 352', 452, 452' (e.g., drain terminal) of the carrier amplifier 350, 350', 450, 450' is electrically coupled to the output combiner circuit 380, 380', 480, 480'. The output combiner circuit 380, 380', 480, 480' is configured to provide an impedance inversion, and also to impart a phase shift to the amplified carrier signal produced at the carrier amplifier output 352, 352', 452, 452'. According to one or more embodiments, each output combiner circuit 380, 380', 480, 480' includes first and second, series-connected inductive elements 381, 381', 382, 382' (e.g., one or more first wirebonds 481, 481' and one or more second wirebonds 482, 482'), a shunt capacitor 383, 383', 483, 483', and a combining node 386, 386', 486, 486'. As will be discussed in more detail later, the combining node 386, 386', 486, 486' may be co-located with the output 372, 372', 472, 472' of the peaking amplifier 370, 370', 470, 470'. Further, as used herein, the term "shunt" means electrically coupled between a circuit node (e.g., terminal 327, 327', 427, 427') and a ground reference node (or other DC voltage reference). The ground reference node may be, for example, a ground reference 485 of the transmitter substrate 301, 401.

According to one or more embodiments, the first and second inductive elements 381, 381', 382, 382', 481, 481', 482, 482' are coupled in series between the carrier amplifier output 352, 352', 452, 452' and the combining node 386, 386', 486, 486', with an intermediate node (corresponding to shunt circuit access terminals 327, 327', 427, 427') between each series-connected set of first and second inductive elements 381, 381', 382, 382', 481, 481', 482, 482'. For example, each first inductive element 381, 381' may be implemented as a first set of wirebonds 481, 481', where each wirebond has a first end coupled to the carrier amplifier output 352, 352', 452, 452', and a second end coupled to the shunt circuit access terminal 327, 327', 427, 427'. Each second inductive element 382, 382' may be implemented as a second set of wirebonds 482, 482', where each wirebond has a first end coupled to the shunt circuit access terminal 327, 327', 427, 427', and a second end coupled to the combining node 386, 386', 486, 486' (e.g., to the peaking amplifier output 352, 352', 452, 452'). In alternate embodiments, the first and second inductive elements 381, 381', 382, 382' may be implemented using conductive traces, rather than wirebonds.

According to one or more embodiments, the total electrical length of the first and second inductive elements 381, 381', 382, 382', 481, 481', 482, 482' is about 90 degrees (i.e., exactly 90 degrees or between about 85 and 95 degrees). Accordingly, the first and second inductive elements 381, 381', 382, 382', 481, 481', 482, 482' impart about 90 degrees of phase delay to the amplified carrier signal between the carrier amplifier output 352, 352', 452, 452' and the combining node 386, 386', 486, 486'. As discussed in more detail below, this phase shift has the result of phase-aligning the amplified carrier signal with the amplified peaking signal when they arrive at the combining node 386, 386', 486, 486'.

As best shown in FIG. 4, each shunt circuit access terminal 427, 427' (or "intermediate node") is coupled to a conductive pad 484, 484' on the transmitter substrate 301, 401. Further, according to one or more further embodiments, a shunt capacitor 383, 383', 483, 483' is coupled to the transmitter substrate 301, 401 between the conductive pad 484, 484' and a ground reference 485 of the transmitter substrate 301, 401. More specifically, each shunt capacitor 383, 383', 483, 483' may have a first terminal connected to the conductive pad 484, 484', and a second terminal coupled to a ground reference 485 of the transmitter substrate 301, 401.

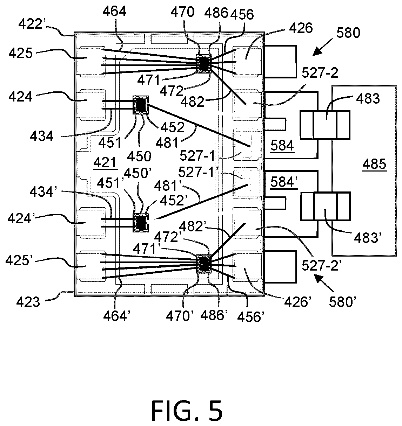

In the embodiment illustrated in FIGs 3 and 4, the shunt capacitors 483, 483' form portions of the external circuitry, and they are electrically coupled with the internal circuitry of device 322, 422 through a single shunt circuit access terminal 327, 327', 427, 427'. Referring briefly to FIG. 5, according to an alternate embodiment, an RF amplifier device 422' may include two shunt circuit access terminals 527-1, 527-1', 527-2, 527-2' to provide access from the internal circuitry of device 422' to shunt capacitors 483, 483' that are external to the device 422'.

RF amplifier device 422' (FIG. 5) is substantially identical to RF amplifier device 422 (FIG. 4), and to the extent that various features of device 422' are the same as features of device 422, the same reference numbers are used. For the purpose of brevity, the details of all of the identical features of device 422' that are discussed elsewhere in conjunction with device 422, those details are not repeated here. Instead, it should be understood that the description (and embodiments) of any features of device 422' that have identical reference numbers as device 422 is incorporated herein to this brief description of device 422'.

Specifically, RF amplifier device 422' includes a discrete package body 423, first through fourth amplifier input terminals 424, 424', 425, 425', first and second output terminals 426, 426', first and second carrier amplifier dies 450, 450' coupled to a conductive flange 421 of the package body 423, first and second peaking amplifier dies 470, 470' coupled to the conductive flange 421, and various inductive elements (e.g., wirebonds 434, 434', 464, 464') electrically coupling the input terminals 424, 424', 425, 425' to the carrier and peaking amplifier dies 450, 450', 470, 470'. In addition, an output combiner circuit 580, 580' is electrically coupled between the output 452, 452' of each carrier amplifier die 450, 450' and a combining node 486, 486'.

The output combiner circuits 580, 580' illustrated in FIG. 5 are different from the output combiner circuits 480, 480' of FIG. 4. More specifically, each output combiner circuit 580, 580' includes two shunt circuit access terminals 527-1, 527-1', 527-2, 527-2', rather than only a single shunt circuit access terminal. Additionally, the output combiner circuits 580, 580' include conductive paths 584, 584' on the transmitter substrate, rather than simple conductive pads (e.g., pads 484, 484', FIG. 4). In the embodiment of FIG. 5, the shunt capacitors 483, 483' are electrically coupled between the conductive paths 584, 584' and the ground reference 485 of the transmitter substrate.

In FIG. 5, the first and second inductive elements 481, 481', 482, 482' still are coupled in series between the carrier amplifier output 352, 352', 452, 452' and the combining node 386, 386', 486, 486'. However, the shunt circuit access terminals 527-1, 527-1', 527-2, 527-2' and the conductive path 584, 584' also are connected in series between the first and second inductive elements 481, 481', 482, 482'. More specifically, each wirebond 481, 481' corresponding to a first inductive element of the output combiner circuit 580, 580' has a first end coupled to the carrier amplifier output 352, 352', 452, 452', and a second end coupled to a first shunt circuit access terminal 527-1, 527-1'. Further, each wirebond 482, 482' corresponding to a second inductive element of the output combiner circuit 580, 580' has a first end coupled to the peaking amplifier output 472, 472' (i.e., to the combining node 486, 486'), and a second end coupled to a second shunt circuit access terminal 527-2, 527-2'. Each pair of shunt circuit access terminals (e.g., a first pair consisting of terminals 527-1 and 527-2, and a second pair consisting of terminals 527-1' and 527-2') is electrically coupled through one of the conductive paths 584, 584' on the transmitter substrate. Because each of the conductive paths 584, 584' have an electrical length between the first terminals 527-1, 527-1' and the second terminals 527-2, 527-2', each of the conductive paths 584, 584' contribute to the total electrical length through the output combiner circuits 580, 580'. Additionally, the shunt circuit access terminals 527-1, 527-1', 527-2, 527-2' also contribute a small amount of electrical length to the total electrical length through the output combiner circuits 580, 580'. According to one or more embodiments, within each output combiner circuit 580, 580', the total electrical length of the first and second inductive elements 481, 481', 482, 482', the shunt circuit access terminals 527-1, 527-1', 527-2, 527-2', and the conductive path 584, 584' is about 90 degrees (i.e., exactly 90 degrees or between about 85 and 95 degrees).

Regardless of the number of shunt circuit access terminals included in the device 322, 422, 422', the capacitance value of each shunt capacitor 383, 383', 483, 483' may be selected to "tune" each Doherty power amplifier 316, 316', 416, 416' for optimal performance within a particular operational frequency band. In other words, when the shunt capacitor 383, 383', 483, 483' has a first capacitance value, inclusion of that capacitor in an output combiner circuit 380, 380', 480', 480' may tune the Doherty power amplifier 316, 316', 416, 416' for optimal performance within a first operational frequency band (e.g., 1805-1880 MHz). Conversely, when the shunt capacitor 383, 383', 483, 483' has a second capacitance value, inclusion of that capacitor in the output combiner circuit 380, 380', 480', 480' may tune the Doherty power amplifier 316, 316', 416, 416' for optimal performance within a second and different operational frequency band (e.g., 2110-2170 MHz).

As indicated above the shunt capacitors 383, 383', 483, 483' are part of the "external circuitry" of each Doherty power amplifier 316, 316', 416, 416', In other words, the shunt capacitors 383, 383', 483, 483' are physically coupled to the transmitter substrate 301, 401, and are not integrated within the devices 322, 422. Externalizing the shunt capacitors 383, 383', 483, 483' has the advantageous effect of enabling identical packaged amplifier devices 322, 422 to be used in multiple transmitters (e.g., transmitters 108, FIG. 1), even when the multiple transmitters are intended for operation at different operational frequencies. In addition, the multiple transmitters all may have the same layout on a transmitter substrate 101, 201, 301, 401. All that is needed to optimize a particular amplification stage 110, 210, 310, 410 for operation at a particular frequency is to attach a shunt capacitor 383, 383', 483, 483' with a capacitance value selected for that frequency to the transmitter substrate 101, 201, 301, 401.

The peaking amplification path 360, 360' is coupled between the second splitter output 320, 320' and the combining node 386, 386', 486, 486' of the output combiner circuit 380, 380', 480, 480'. Each peaking amplification path 360, 360'includes a series of conductive elements between the second splitter output 320, 320' and the peaking amplifier 370, 370', 470, 470', and the peaking amplifier 370, 370', 470, 470'. The series of conductive elements of the peaking amplification path 360, 360' includes: 1) a conductive trace (not numbered) on the transmitter substrate 301, 401 between the second splitter output 320, 320' and the second or fourth amplifier input terminals 325, 325', 425, 425'; 2) one of the second or fourth amplifier input terminals 325, 325', 425, 425' of the device 322, 422; and 3) an inductive element 364, 364' (e.g., one or more wirebonds 464, 464') within the device 322, 422 between the second or fourth amplifier input terminal 325, 325', 425, 425' and the peaking amplifier 370, 370'.

Distal ends of the second and fourth amplifier input terminals 325, 325', 425, 425' are coupled (e.g., soldered) to ends of the conductive traces (or to conductive pads) on the transmitter substrate 301, 401. Each inductive element 364, 364', 464, 464' provides an electrical connection between one of the second and fourth amplifier input terminals 325, 325', 425, 425' and an input 371, 371', 471, 471' to the peaking amplifier 370, 370', 470, 470'. As shown in FIG. 4, each inductive element 364, 364' may be implemented as one or more wirebonds 464, 464' between the second or fourth amplifier input terminals 325, 325', 425, 425' and the input 371, 371', 471, 471' to the peaking amplifier 370, 370', 470, 470'. In addition, the inductive element 364, 364', 464, 464' may form a portion of an optional peaking IMN 362, 362'. When included, the peaking IMN 362, 362' is configured to incrementally increase the circuit impedance. For example, but not by way of limitation, the peaking IMN 362, 362' may include, for example, a lowpass or bandpass circuit configured as a T- or pi- impedance matching network, where the inductive element 364, 364', 464, 464' provides a series inductance in the circuit.

As mentioned above, each peaking amplifier 370, 370' may be implemented as a power transistor in a peaking amplifier die 470, 470', which is physically and electrically coupled to the conductive flange 421 of the package body 323, 423. As used herein, "peaking amplifier" and "peaking amplifier die" may be used interchangeably. Each peaking amplifier 370, 370', 470, 470' has a peaking amplifier input 371, 371', 471, 471' (e.g., a gate terminal) and two current-carrying terminals (e.g., drain and source terminals). As indicated above, the peaking amplifier input 371, 371', 471, 471' is coupled through inductive element 364, 364', 464, 464' (and/or through the peaking IMN 362, 362') to the second or fourth amplifier input terminal 325, 325'. One of the current-carrying terminals (e.g., the drain terminal) of the peaking amplifier 370, 370', 470, 470' functions as a peaking amplifier output 372, 372', 472, 472', at which an amplified peaking signal is produced by the peaking amplifier 370, 370', 470, 470'. The other current-carrying terminal (e.g., the source terminal) of the peaking amplifier 370, 370', 470, 470' may be coupled to a ground reference node (e.g., to the conductive flange 421).

The peaking amplifier 370, 370', 470, 470' is configured to amplify the peaking input RF signal received at the peaking amplifier input 371, 371', 471, 471', and to produce an amplified peaking signal at the peaking amplifier output 372, 372', 472, 472'. As mentioned previously, the peaking amplifier output 372, 372', 472, 472' may be co-located with the combining node 386, 386', 486, 486' of the output combiner circuit 380, 380', 480, 480'. For example, the peaking amplifier output 372, 372', 472, 472' and the combining node 386, 386', 486, 486' may be a same conductive feature (e.g., a drain terminal of the peaking amplifier 370, 370', 470, 470'). Accordingly, an electrical distance between the peaking amplifier output 372, 372', 472, 472' and the combining node 386, 386', 486, 486' may be about zero degrees.

Each combining node 386, 386', 486, 486' is configured to combine the amplified carrier signal and the amplified carrier signal received at that node, in order to produce an amplified output signal for each Doherty power amplifier 316, 316', 416, 416'. According to one or more embodiments, inductive element 356, 356', 456, 456' is electrically connected between the combining node 386, 386', 486, 486' and the first or second output terminal 326, 326', 426, 426'. For example, the inductive element 356, 356' may be implemented as one or more wirebonds 456, 456' between the combining node 386, 386', 486, 486' and the first or second output terminal 326, 326', 426, 426'.

Once an amplified output signal is produced at each of the first and second output terminals 326, 326', 426, 426', those output signals are combined by the signal combiner 388, 488, as discussed above in detail.

As a side note, and as illustrated in FIG. 4, first and second DC bias circuits 428, 428', 429, 429' are coupled to the inputs 351, 351', 371, 371', 451, 451', 471, 471' (e.g., gate terminals) of the carrier and peaking amplifiers 350, 350', 370, 370', 450, 450', 470, 470'. Further, third DC bias circuits 431, 431' are coupled to the outputs 351, 351', 371, 371', 451, 451', 471, 471' (e.g., drain terminals) of the carrier and peaking amplifiers 350, 350', 370, 370', 450, 450', 470, 470'. These DC bias circuits 428, 428', 429, 429', 431, 431' convey gate and drain DC bias voltages, respectively, that will ensure proper operation of the Doherty power amplifiers 316, 316', 416, 416' within the amplification stage 310, 410. More specifically, during operation of the amplification stage 310, 410, each of the carrier amplifiers 350, 350', 450, 450' may be biased to operate in class AB mode or deep class AB mode, and each of the peaking amplifiers 370, 370', 470, 470' may be biased to operate in class C mode or deep class C mode.

At low to moderate input signal power levels (i.e., where the power of an input signals at the input to the first or second Doherty power amplifier 316, 316', 416, 416' is lower than the turn-on threshold level of the associated peaking amplifier 370, 370', 470, 470'), the Doherty power amplifier 316, 316', 416, 416' operates in a low-power mode in which the carrier amplifier 350, 350', 450, 450' operates to amplify the input signal, and the peaking amplifier 370, 370', 470, 470' is minimally conducting (e.g., the peaking amplifier 370, 370', 470, 470' essentially is in an off state). Conversely, as the input signal power increases to a level at which the carrier amplifier 350, 350', 450, 450' reaches voltage saturation, the signal splitter 317, 317', 417, 417' divides the energy of the input signal between the carrier and peaking amplifier paths 330, 330', 360, 360', and both amplifiers 350, 350', 370, 370', 450, 450', 470, 470' operate to amplify their respective portion of the input signal.

As the input signal level increases beyond the point at which the carrier amplifier 350, 350', 450, 450' is operating in compression, the peaking amplifier 370, 370', 470, 470' conduction also increases, thus supplying more current to output terminal 326, 326', 426, 426'. In response, the load line impedance of the carrier amplifier output decreases. In fact, an impedance modulation effect occurs in which the load line of the carrier amplifier 350, 350', 450, 450' changes dynamically in response to the input signal power (i.e., the peaking amplifier 370, 370', 470, 470' provides active load pulling to the carrier amplifier 350, 350', 450, 450'). The output combiner circuit 380, 380', 480, 480', transforms the carrier amplifier load line impedance to a high value at backoff, allowing the carrier amplifier 350, 350', 450, 450' to efficiently supply power to the output terminal 326, 326', 426, 426' over an extended output power range.

The embodiments of amplification stages 310, 410 discussed in conjunction with FIGs 3-5 correspond to physical implementations of dual 90/0 Doherty power amplifiers, as discusses above. As a reminder, a 90/0 Doherty power amplifier has an output combining circuit (e.g., circuits 380, 380', 480, 480', 580, 580', FIGs 3-5) in which an electrical length between the output of a first amplifier or amplifier die (e.g., amplifier 350 or amplifier die 450, FIGs 3, 4) and a combining node (e.g., combining node 386, 386', 486, 486', FIGs 3-5) is about 90 degrees, and in which an electrical length between the output of a second amplifier or amplifier die (e.g., amplifier 370 or amplifier die 470, FIGs 3-5) and a combining node (e.g., combining node 386, 386', 486, 486', FIGs 3-5) is about zero degrees.

According to one or more other embodiments, an amplification stage may include one or more Doherty power amplifiers, each with an output combining circuit in which an electrical length between the output of a first amplifier or amplifier die and a combining node is about 90 degrees, and in which an electrical length between the output of a second amplifier or amplifier die and a combining node is about 180 degrees. Such a Doherty power amplifier is referred to as a "90/180 Doherty power amplifier."

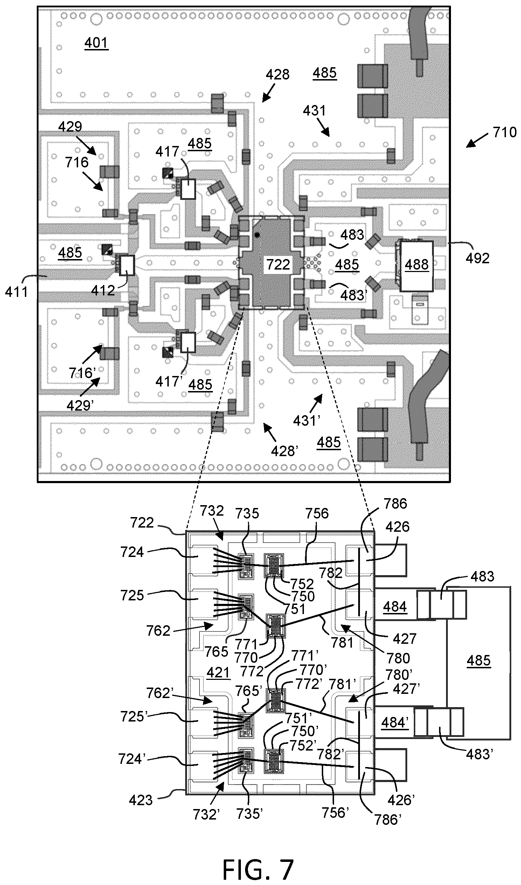

FIG. 6 is a schematic drawing of an amplification stage 610 (e.g., amplification stage 110, 210, FIGs 1, 2) that includes a dual 90/180 Doherty power amplifier with tunable output combiner circuits, in accordance with an example embodiment. For enhanced understanding, FIG. 6 should be viewed simultaneously with FIG. 7, which is a top view of a physical implementation of an amplification stage 710 that includes the dual 90/180 Doherty power amplifier of FIG. 6.

Again, some terminology may be useful at this point. In particular, the term "90/180 Doherty power amplifier" means a Doherty power amplifier that has an output combining circuit (e.g., circuits 680, 680', 780, 780', FIGs 6, 7) in which an electrical length between the output of one amplifier or amplifier die (e.g., amplifier 650 or amplifier die 750, FIGs 6, 7) and a combining node (e.g., combining node 686, 686', 786, 786', FIGs 6, 7) is about 90 degrees (i.e., exactly 90 degrees or between about 85 and 95 degrees), and in which an electrical length between the output of another amplifier or amplifier die (e.g., amplifier 670 or amplifier die 770, FIGs 6, 7) and a combining node (e.g., combining node 686, 686', 786, 786', FIGs 6, 7) is about 180 degrees (e.g., exactly 180 degrees or between about 170 and 190 degrees).

The amplification stage 610, 710 essentially includes a dual 90/180 Doherty power amplifier coupled to the transmitter substrate 301, 401, which includes a first Doherty power amplifier 616, 716 and a second Doherty power amplifier 616', 716' arranged in parallel. More particularly, amplification stage 610, 710 includes a transmitter input terminal 311, 411, a first signal power splitter 312, 412, the first Doherty power amplifier 616, 716, the second Doherty power amplifier 616', 716', a signal power combiner 388, 488, and a transmitter output terminal 392, 492.

The "external circuitry" of RF amplifier stages 310, 410 may be similar or identical to the "external circuitry" of RF amplifier stages 610, 710. More specifically, as with RF amplifier stages 310, 410, RF amplifier stages 610, 710 also include a transmitter substrate 301, 401, an RF input 311, 411, and first, second, and third signal splitters 312, 317, 317', 412, 417, 417' mounted on the transmitter substrate 301, 401. The RF input 311, 411 and the first, second, and third signal splitters 312, 317, 317', 412, 417, 417' all may be electrically coupled together as described previously in conjunction with FIGs 3 and 4.

In addition, as with RF amplifier stages 310, 410, the external circuitry of RF amplifier stages 610, 710 also includes various conductive traces that electrically connect the various outputs 319, 319', 320, 320' of the second and third signal splitters 317, 317', 417, 417' with amplifier input terminals 624, 624', 625, 625', 724, 724', 725, 725'. The amplifier input terminals 624, 624', 625, 625', 724, 724', 725, 725' have the same physical and electrical characteristics as the amplifier input terminals 324, 324', 325, 325', 424, 424', 425, 425' (FIGs 3, 4). Further, as with RF amplifier stages 310, 410, the external circuitry of RF amplifier stages 610, 710 also includes a signal combiner 388, 488 on the transmitter substrate 301, 401, and additional conductive traces that electrically connect first and second amplifier output terminals 326, 326' 426, 426' of device 622, 722 to inputs 389, 390 of the signal combiner 388, 488. Further still, as with RF amplifier stages 310, 410, the external circuitry of RF amplifier stages 610, 710 also includes shunt capacitors 383, 383' on the transmitter substrate 301, 401, which are coupled (e.g., through conductive pads 484, 484') to shunt circuit access terminals 327, 327', 427, 427' of device 622, 722. The details of the external circuitry associated with RF amplifier stages 610, 710 will not be repeated here, for brevity, but instead the description of the details of the identical circuitry discussed previously in conjunction with FIGs 3 and 4 is incorporated into this description of FIGs 6 and 7.

In addition, RF amplifier devices 622, 722 are substantially similar to RF amplifier devices 322, 422 (FIGs 3, 4), and to the extent that various features of devices 622, 722 are the same as features of devices 322, 422, the same reference numbers are used. For the purpose of brevity, the details of all of the identical features of devices 622, 722 that are discussed elsewhere in conjunction with devices 322, 422, those details are not repeated here. Instead, it should be understood that the description (and embodiments) of any features of devices 622, 722 that have identical reference numbers as devices 322, 422 is incorporated herein to this brief description of devices 622, 722. It should be noted also that carrier amplifiers (and amplifier dies) 650, 650', 750, 750' are the same as carrier amplifiers (and amplifier dies) 350, 350', 450, 450' (FIGs 3, 4), peaking amplifiers 670, 670', 770, 770' are the same as peaking amplifiers 370, 370', 470, 470' (FIGs 3, 4), and all details associated with the carrier and peaking amplifiers (and amplifier dies) discussed above in conjunction with FIGs 3 and 4 are incorporated into this description of the carrier and peaking amplifiers (and amplifier dies) of FIGs 6 and 7.

Specifically, RF amplifier devices 622, 722 includes a discrete package body 423, first through fourth amplifier input terminals 624, 624', 625, 625', 724, 724', 725, 725', first and second output terminals 326, 326', 426, 426', first and second shunt circuit access terminals 327, 327', 427, 427', first and second carrier amplifiers (amplifier dies) 650, 650', 750, 750' coupled to a conductive flange 421 of the package body 423, and first and second peaking amplifiers (amplifier dies) 670, 670', 770, 770' coupled to the conductive flange 421.

In the embodiment of FIGs 6 and 7, input matching networks (IMNs) 632, 632', 662, 662', 732, 732', 762, 762' are electrically coupled between the input terminals 624, 624', 625, 625', 724, 724', 725, 725' and the carrier and peaking amplifiers (amplifier dies) 650, 650', 670, 670', 750, 750', 770, 770'. According to one or more embodiments, the IMNs 632, 632', 662, 662', 732, 732', 762, 762' each include an integrated passive device 635, 635', 665, 665', 735, 735', 765, 765' coupled to the conductive flange 421, where the integrated passive device 735, 735', 765, 765' includes a shunt capacitor and possibly other circuitry. Each IMN 632, 632', 662, 662', 732, 732', 762, 762' also includes first and second inductive elements (e.g., wirebonds) coupled in series between the amplifier input terminals 624, 624', 625, 625', 724, 724', 725, 725' and the carrier and peaking amplifiers (amplifier dies) 650, 650', 670, 670', 750, 750', 770, 770'.

The differences between RF amplifier devices 622, 722 and RF amplifier devices 322, 422 will now be discussed in detail. Specifically, because amplifier stage 610, 710 includes 90/180 Doherty power amplifiers (rather than 90/0 Doherty power amplifiers), the output combiner circuits 680, 680', 780, 780' illustrated in FIGs 6 and 7 are different from the output combiner circuits 380, 380', 480, 480' of FIGs 3 and 4.

Referring to FIGs 6 and 7, the outputs 652, 652', 672, 672', 752, 752', 772, 772' (e.g., drain terminals) of both the carrier amplifier 650, 650', 750, 750' and the peaking amplifier 670, 670', 770, 770' are electrically coupled to an output combiner circuit 680, 680', 780, 780'. The output combiner circuit 680, 680', 780, 780' is configured to provide an impedance inversion, and also to impart a phase shift to the amplified peaking signal produced at the peaking amplifier output 672, 672', 772, 772'. In addition, the output combiner circuit 680, 680', 780, 780' also is configured to impart a phase shift to the amplified carrier signal produced at the carrier amplifier output 652, 652', 752, 752'.

According to one or more embodiments, each output combiner circuit 680, 680', 780, 780' includes a first inductive element 656, 656' (e.g., one or more first wirebonds 756, 756'), second and third, series-connected inductive elements 681, 681', 682, 682' (e.g., one or more second wirebonds 781, 781' and one or more third wirebonds 782, 782'), a shunt capacitor 383, 383', 483, 483', and a combining node 686, 686', 786, 786'. As will be discussed in more detail later, the combining node 686, 686', 786, 786' may be co-located with the first and second output terminals 326, 326', 426, 426'.

According to one or more embodiments, the first inductive element 656, 656', 756, 756' is electrically coupled between the carrier amplifier output 652, 652', 752, 752' and the combining node 686, 686', 786, 786' (e.g., the first or second output terminal 326, 326', 426, 426'). For example, each first inductive element 656, 656' may be implemented as a first set of wirebonds 756, 756', where each wirebond has a first end coupled to the carrier amplifier output 652, 652', 752, 752', and a second end coupled to the first or second output terminal 326, 326', 426, 426' (e.g., the combining node 686, 686', 786, 786'). According to one or more embodiments, the electrical length of the first inductive element 656, 656', 756, 756' is about 90 degrees (i.e., exactly 90 degrees or between about 85 and 95 degrees). Accordingly, the first inductive element 656, 656', 756, 756' imparts about 90 degrees of phase delay to the amplified carrier signal between the carrier amplifier output 652, 652', 752, 752' and the combining node 686, 686', 786, 786'.

The second and third inductive elements 681, 681', 682, 682', 781, 781', 782, 782' are coupled in series between the peaking amplifier output 672, 672', 772, 772' and the combining node 686, 686', 786, 786', with an intermediate node (corresponding to shunt circuit access terminals 327, 327', 427, 427') between each series-connected set of second and third inductive elements 681, 681', 682, 682', 781, 781', 782, 782'. For example, each second inductive element 681, 681' may be implemented as a second set of wirebonds 781, 781', where each wirebond has a first end coupled to the peaking amplifier output 672, 672', 772, 772', and a second end coupled to the shunt circuit access terminal 327, 327', 427, 427'. Each third inductive element 682, 682' may be implemented as a third set of wirebonds 782, 782', where each wirebond has a first end coupled to the shunt circuit access terminal 327, 327', 427, 427', and a second end coupled to the combining node 686, 686', 786, 786' (e.g., to the first or second output terminal 326, 326', 426, 426'). In alternate embodiments, the second and third inductive elements 681, 681', 682, 682' may be implemented using conductive traces, rather than wirebonds.

According to one or more embodiments, the total electrical length of the second and third inductive elements 681, 681', 682, 682', 781, 781', 782, 782' is about 180 degrees (i.e., exactly 180 degrees or between about 170 and 190 degrees). Accordingly, the second and third inductive elements 681, 681', 682, 682', 781, 781', 782, 782' impart about 180 degrees of phase delay to the amplified peaking signal between the peaking amplifier output 672, 672', 772, 772' and the combining node 686, 686', 786, 786'.

As best shown in FIG. 7, each shunt circuit access terminal 427, 427' (or "intermediate node") is coupled to a conductive pad 484, 484' on the transmitter substrate 301, 401. Further, according to one or more further embodiments, a shunt capacitor 383, 383', 483, 483' is coupled to the transmitter substrate 301, 401 between the conductive pad 484, 484' and a ground reference 485 of the transmitter substrate 301, 401. More specifically, each shunt capacitor 383, 383', 483, 483' may have a first terminal connected to the conductive pad 484, 484', and a second terminal coupled to a ground reference 485 of the transmitter substrate 301, 401. Once again, the capacitance value of each shunt capacitor 383, 383', 483, 483' may be selected to "tune" each Doherty power amplifier 616, 616', 716, 716' for optimal performance at a particular operational frequency. Additionally, as discussed above, externalizing the shunt capacitors 383, 383', 483, 483' has the advantageous effect of enabling identical packaged amplifier devices 622, 722 to be used in multiple transmitters (e.g., transmitters 108, FIG. 1), even when the multiple transmitters are intended for operation at different operational frequencies. In addition, the multiple transmitters all may have the same layout on a transmitter substrate 101, 201, 301, 401. All that is needed to optimize a particular amplification stage 610, 710 for operation at a particular frequency is to attach a shunt capacitor 383, 383', 483, 483' with a capacitance value selected for that frequency to the transmitter substrate 101, 201, 301, 401.

An embodiment of an RF amplifier includes a discrete package body, and a first signal output terminal, a second signal output terminal, one or more first shunt circuit access terminals, and one or more second shunt circuit access terminals connected to the discrete package body. First, second, third, and fourth power amplifiers also are connected to the discrete package body. The first power amplifier also includes a first amplifier output, which is electrically coupled through a first inductive element to the first signal output terminal and is electrically coupled through a second inductive element to the one or more first shunt circuit access terminals. The second power amplifier also includes a second amplifier output, which is electrically coupled through a third inductive element to the one or more first shunt circuit access terminals. The third power amplifier includes a third amplifier output, which is electrically coupled through a fourth inductive element to the second signal output terminal and is electrically coupled through a fifth inductive element to the one or more second shunt circuit access terminals. The fourth power amplifier includes a fourth amplifier output, which is electrically coupled through a sixth inductive element to the one or more second shunt circuit access terminals. The RF amplifier also includes a first output combiner circuit that includes the second and third inductive elements, and a second output combiner circuit that includes the fifth and sixth inductive elements.

According to a further embodiment, the first amplifier output corresponds to a first combining node of the first output combiner circuit, and a first electrical length between the first amplifier output and the second amplifier output through the second and third inductive elements is about 90 degrees.

According to another further embodiment, the first signal output terminal corresponds to a first combining node of the first output combiner circuit, the one or more first shunt circuit access terminals consists of a single first shunt circuit access terminal, the second amplifier output is electrically connected through the third inductive element to the to the single first shunt circuit access terminal, and the second inductive element has a first end connected to the first signal output terminal and a second end connected to the single first shunt circuit access terminal. In such an embodiment, a first electrical length between the second amplifier output and the first signal output terminal through the second and third inductive elements is about 180 degrees, and a second electrical length between the first amplifier output and the first signal output terminal through the first inductive element is about 90 degrees.

Another embodiment of an RF amplifier device includes a discrete package body, and a first signal output terminal, a first shunt circuit access terminal, and first and second power amplifiers connected to the discrete package body. The first power amplifier includes a first amplifier output electrically coupled through a first inductive element to the first signal output terminal. A second inductive element has a first end coupled to the first signal output terminal and a second end coupled to the first shunt circuit access terminal. The second power amplifier includes a second amplifier output electrically coupled through a third inductive element to the first shunt circuit access terminal. A first output combiner circuit includes the first, second, and third inductive elements, where the first signal output terminal corresponds to a first combining node of the first output combiner circuit.

According to a further embodiment, a first electrical length between the second amplifier output and the first signal output terminal through the second and third inductive elements is about 180 degrees, and a second electrical length between the first amplifier output and the first signal output terminal through the first inductive element is about 90 degrees.

An embodiment of an RF transmitter includes a transmitter substrate and an amplifier coupled to the transmitter substrate. The amplifier includes a transmitter input terminal, a transmitter output terminal, and the radio frequency amplifier device of the previous paragraph, which is physically coupled to the transmitter substrate. The radio frequency amplifier device also includes one or more first amplifier input terminals and one or more second amplifier input terminals. A first signal power splitter is physically coupled to the transmitter substrate and has a first splitter input terminal, a first splitter output terminal, and a second splitter output terminal. The first splitter input terminal is electrically coupled to the transmitter input terminal, the first splitter output terminal is electrically coupled to the one or more first amplifier input terminals, and the second splitter output terminal is electrically coupled to the one or more second amplifier input terminals. A first capacitor is physically coupled to the first transmitter substrate and has a first capacitor terminal coupled to the one or more first shunt circuit access terminals and a second capacitor terminal coupled to a ground reference of the transmitter substrate. A second capacitor is physically coupled to the transmitter substrate and has a third capacitor terminal coupled to the one or more second shunt circuit access terminals and a fourth capacitor terminal coupled to the ground reference of the first transmitter substrate. The RF transmitter also includes a signal power combiner physically coupled to the transmitter substrate, which has a first combiner input terminal, a second combiner input terminal, and a combiner output terminal. The first combiner input terminal is electrically coupled to the first signal output terminal, and the second combiner input terminal is electrically coupled to the second signal output terminal.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or detailed description.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A radio frequency amplifier device (322, 422, 422', 622, 722) comprising:
a discrete package body (323, 423);
a first signal output terminal (326, 426) and a second signal output terminal (326', 426') connected to the discrete package body;
one or more first shunt circuit access terminals (327, 427, 527-1, 527-2) and one or more second shunt circuit access terminals (327', 427', 527-1', 527-2'), connected to the discrete package body;
a first power amplifier (370, 470, 650, 750) connected to the discrete package body and including a first amplifier output (372, 472, 652, 752) electrically coupled through a first inductive element (356, 456, 656, 756) to the first signal output terminal and electrically coupled through a second inductive element (382, 482, 682, 782) to the one or more first shunt circuit access terminals (327, 427, 527-2);
a second power amplifier (350, 450, 670, 770) connected to the discrete package body and including a second amplifier output (352, 452, 672, 772) electrically coupled through a third inductive element (381, 481, 681, 781) to the one or more first shunt circuit access terminals (327, 427, 527-1);
a first output combiner circuit (380, 480, 680, 780) that includes the second and third inductive elements;
a third power amplifier (370', 470', 650', 750') connected to the discrete package body and including a third amplifier output (372', 472', 652', 752') electrically coupled through a fourth inductive element (356', 456', 656', 756') to the second signal output terminal and electrically coupled through a fifth inductive element (382', 482', 682', 782') to the one or more second shunt circuit access terminals (327', 427', 527-2');
a fourth power amplifier (350', 450', 670', 770') connected to the discrete package body and including a fourth amplifier output (352', 452', 672', 772') electrically coupled through a sixth inductive element (381', 481', 681', 781') to the one or more second shunt circuit access terminals (327', 427', 527-1'); and
a second output combiner circuit (380', 480', 680', 780') that includes the fifth and sixth inductive elements.

2. The radio frequency amplifier device of claim 1, wherein:
the one or more first shunt circuit access terminals consists of two first shunt circuit access terminals (527-1, 527-2), the first amplifier output is electrically coupled through the second inductive element to one of the two first shunt circuit access terminals, and the second amplifier output is electrically coupled through the third inductive element to another one of the two first shunt circuit access terminals.

3. The radio frequency amplifier device of claim 1, wherein:
the one or more first shunt circuit access terminals consists of a single first shunt circuit access terminal (327, 427, 627, 727), and both the first amplifier output and the second amplifier output are electrically coupled through the second and third inductive elements, respectively, to the single first shunt circuit access terminal.

4. The radio frequency amplifier device of claim 3, wherein:
the first amplifier output corresponds to a first combining node (386, 486) of the first output combiner circuit; and
a first electrical length between the first amplifier output and the second amplifier output through the second and third inductive elements is about 90 degrees.

5. The radio frequency amplifier device of claim 1, wherein:
the first signal output terminal (326, 426) corresponds to a first combining node (686, 786) of the first output combiner circuit;
the one or more first shunt circuit access terminals consists of a single first shunt circuit access terminal (327, 427);
the second amplifier output is electrically connected through the third inductive element to the to the single first shunt circuit access terminal; and
the second inductive element has a first end connected to the first signal output terminal and a second end connected to the single first shunt circuit access terminal.

6. The radio frequency amplifier device of claim 5, wherein:
a first electrical length between the second amplifier output and the first signal output terminal through the second and third inductive elements is about 180 degrees; and
a second electrical length between the first amplifier output and the first signal output terminal through the first inductive element is about 90 degrees.

7. The radio frequency amplifier device of any preceding claim, further comprising:
a first amplifier input terminal (325, 425, 624, 724) and a second amplifier input terminal (324, 424, 625, 725) connected to the discrete package body, wherein
a first amplifier input (371, 471, 651, 751) of the first power amplifier (370, 470, 650, 750) is electrically coupled to the first amplifier input terminal; and
a second amplifier input (351, 451, 671, 771) of the second power amplifier (350, 450, 670, 770) is electrically coupled to the second amplifier input terminal.

8. The radio frequency amplifier of claim 7, further comprising:
a first impedance matching circuit (362, 632) that electrically couples the first amplifier input and the first amplifier input terminal; and
a second impedance matching circuit (332, 662) that electrically couples the second amplifier input and the second amplifier input terminal.

9. The radio frequency amplifier of any preceding claim, wherein:
the first signal output terminal, the one or more first shunt circuit access terminals, the first power amplifier, the second power amplifier, the first, second, and third inductive elements, and the first output combiner circuit form portions of a first Doherty power amplifier (316, 416, 616, 716); and
the second signal output terminal, the one or more second shunt circuit access terminals, the third power amplifier, the fourth power amplifier, the fourth, fifth, and sixth inductive elements, and the second output combiner circuit form portions of a second Doherty power amplifier (316', 416', 616', 716').

10. A radio frequency transmitter (108, 208) comprising:
the radio frequency amplifier device according to claim 1
a first transmitter substrate (101, 201, 301, 401); and
a first amplifier (316, 316', 416, 416', 616, 616', 716, 716') coupled to the first transmitter substrate, wherein the first amplifier includes
a transmitter input terminal (311, 411),
a transmitter output terminal (392, 492),
the radio frequency amplifier device is physically coupled to the first transmitter substrate, and further includes one or more first amplifier input terminals (324, 325, 424, 425, 624, 625, 724, 725) and one or more second amplifier input terminals (324', 325', 424', 425', 624', 625', 724', 725'),
a first signal power splitter (312, 412) physically coupled to the first transmitter substrate and having a first splitter input terminal (313), a first splitter output terminal (314), and a second splitter output terminal (315), wherein the first splitter input terminal is electrically coupled to the transmitter input terminal (311, 411), the first splitter output terminal is electrically coupled to the one or more first amplifier input terminals, and the second splitter output terminal is electrically coupled to the one or more second amplifier input terminals,
a first capacitor (383, 483) physically coupled to the first transmitter substrate and having a first capacitor terminal coupled to the one or more first shunt circuit access terminals (327, 427) and a second capacitor terminal coupled to a ground reference (385, 485) of the first transmitter substrate,
a second capacitor (383', 483') physically coupled to the first transmitter substrate and having a third capacitor terminal coupled to the one or more second shunt circuit access terminals (327', 427') and a fourth capacitor terminal coupled to the ground reference of the first transmitter substrate, and
a signal power combiner (388, 488) physically coupled to the first transmitter substrate and having a first combiner input terminal (389), a second combiner input terminal (390), and a combiner output terminal (391), wherein the first combiner input terminal is electrically coupled to the first signal output terminal (326, 426), and the second combiner input terminal is electrically coupled to the second signal output terminal (326', 426').

11. The radio frequency transmitter of claim 10, wherein:
the one or more first amplifier input terminals includes two first amplifier input terminals (324, 325, 424, 425, 624, 625, 724, 725);
the one or more second amplifier input terminals includes two second amplifier input terminals (324', 325', 424', 425', 624', 625', 724', 725'); and
the radio frequency transmitter further includes
a second signal power splitter (317) physically coupled to the first transmitter substrate and having a second splitter input terminal (318), a third splitter output terminal (319), and a fourth splitter output terminal (320), wherein the second splitter input terminal is electrically coupled to the first splitter output terminal of the first signal power splitter, the third splitter output terminal is electrically coupled to one of the two first amplifier input terminals (324, 424, 624, 724), and the fourth splitter output terminal is electrically coupled to another one of the two first amplifier input terminals (325, 425, 625, 725), and
a third signal power splitter (317') physically coupled to the first transmitter substrate and having a third splitter input terminal (318'), a fifth splitter output terminal (319'), and a sixth splitter output terminal (320'), wherein the third splitter input terminal is electrically coupled to the second splitter output terminal of the first signal power splitter, the fifth splitter output terminal is electrically coupled to one of the two second amplifier input terminals (324', 424', 624', 724'), and the sixth splitter output terminal is electrically coupled to another one of the two second amplifier input terminals (325', 425', 625', 725').

12. The radio frequency transmitter of claim 11, wherein:
the second signal power splitter, the two first amplifier input terminals, the first signal output terminal, the one or more first shunt circuit access terminals, the first power amplifier, the second power amplifier, the first, second, and third inductive elements, and the first output combiner circuit form portions of a first Doherty power amplifier (316, 416, 616, 716); and
the third signal power splitter, the two second amplifier input terminals, the second signal output terminal, the one or more second shunt circuit access terminals, the third power amplifier, the fourth power amplifier, the fourth, fifth, and sixth inductive elements, and the second output combiner circuit form portions of a second Doherty power amplifier (316', 416', 616', 716').

13. The radio frequency transmitter of any of claims 10 to 12, wherein:
the first amplifier is a driver amplifier (110, 210) of the radio frequency transmitter (108, 208); and
the radio frequency transmitter further includes
a final-stage amplifier (190, 290) with a final-stage amplifier input electrically coupled to the combiner output terminal.

14. The radio frequency transmitter of any of claims 10 to 13, wherein:
the one or more first shunt circuit access terminals consists of a single first shunt circuit access terminal (327, 427), and both the first amplifier output and the second amplifier output are electrically coupled through the second and third inductive elements, respectively, to the single first shunt circuit access terminal.

15. The radio frequency transmitter of any of claims 10 to 13, wherein:
the one or more first shunt circuit access terminals consists of two first shunt circuit access terminals (527-1, 527-2), the first amplifier output is electrically coupled through the second inductive element to one of the two first shunt circuit access terminals (527-1), and the second amplifier output is electrically coupled through the third inductive element to another one of the two first shunt circuit access terminals (527-2); and
the radio frequency transmitter further includes
a first conductive path (584) coupled to the transmitter substrate and extending between the two first shunt circuit access terminals, wherein the first capacitor terminal of the first capacitor (483) is coupled to the first conductive path.
